# EUROPEAN PATENT APPLICATION

(11) **EP 2 816 882 A2**
(43) Date of publication of application: **24.12.2014**
(21) Application number: 14171419.6
(22) Date of filing: 05.06.2014
(51) Int. Cl.: H05K 13/00

(54) **Discrete area circuit board image projection system and method**

(30) Priority: 20.06.2013 US 201313922847
(71) Applicant: Northrop Grumman Systems Corporation, Falls Church, VA 22042-4511 (US)
(72) Inventor: Apperson, John, WOODLAND HILLS, CA California 91367-6675 (US)
(74) Representative: Curley, Donnacha John

(57) **Abstract**

A discrete area circuit board projection system is provided. The system comprises a controller that executes a circuit board discrete area program based on a circuit layout and generates video signals associated with images of components and/or pins to be displayed in a discrete area location of a circuit board assembly, and a display system that receives the video signal and displays the images of components and/or pins in the discrete area location of the circuit board assembly to facilitate at least one of assembly, test and diagnostic repair of the circuit board assembly.

## Description

### TECHNICAL FIELD

The present invention relates generally to projection systems, and more particularly to discrete area image projection systems and methods.

### BACKGROUND

Manual circuit board assembly by a technician is a difficult and tedious process. For example, a technician assembling a circuit card assembly will either reference a computer screen or paper copy of a schematic drawing of the circuit card assembly that identifies component parts to be soldered or bonded to the circuit board by a parts list that identifies a part by a part number and a reference designator. The technician may need to memorize the component position by the assembly drawing and reference designator, pick up the component, look back at the circuit card assembly, and place the component in the correct position and orientation on the circuit card assembly. This process is then repeated for the next component, until the entire circuit board assembly has been assembled. A similar technique is performed for manually testing and/or manual diagnostics to test and/or repair the circuit board assembly for proper operation.

### SUMMARY

In accordance with one example embodiment, a discrete area circuit board projection system is provided. The system comprises a controller that executes a circuit board discrete area program based on a circuit layout and generates video signals associated with images of components and/or pins to be displayed in a discrete area location of a circuit board assembly, and a display system that receives the video signal and displays the images of components and/or pins in the discrete area location of the circuit board assembly to facilitate at least one of assembly, test and diagnostic repair of the circuit board assembly.
In accordance with one example embodiment, another discrete area circuit board projection system is provided that comprises a controller that executes a circuit board discrete area program based on a circuit layout and generates video signals associated with images of components and/or pins to be displayed in a plurality of discrete area locations of a circuit board assembly. The system further comprises a display system that receives the video signals and displays the images of components and/or pins in the plurality of discrete area locations of the circuit board assembly to facilitate at least one of assembly, test and diagnostic repair of the circuit board assembly, and a user interface that allows a user to sequentially step through displaying of the components and/or pins in a given discrete area location for each of the plurality of discrete area locations. In this exemplary embodiment, the display system may be a projector that projects the images of components and/or pins directly yin the discrete area location of the circuit board assembly. Similarly, the display system may be one of a computer monitor or a projector and screen. The display system may further comprise a camera that captures images of the circuit board assembly and any components and user's fingers in the view of the camera, which are provided to the display system for displaying along with the images of components and/or pins superimposed in the discrete area location of the captured image of the circuit board assembly. The system may comprise a user interface that prompts the user to measure pins of components and/or other pins with a meter or oscilloscope that are displayed in one or more discrete area locations during one of a test and/or diagnostic repair procedure. Similarly, the system may comprise a user interface that allows a user to select at least one of an assembly procedure, a test procedure, a diagnostic test procedure and a discrete component and/or pin to be displayed on a circuit board assembly.

In accordance with another example embodiment, a method is provided for facilitating at least one of assembly, test and diagnostic repair of a circuit board assembly. The method comprises executing a circuit board discrete area program based on a circuit layout to generate video signals associated with images of components and/or pins to be displayed in a plurality of discrete area locations of a circuit board assembly, displaying a user interface that allows a user to sequentially step through displaying of the components and/or pins in a given discrete area location for each of the plurality of discrete area locations, and sequentially displaying the images of components and/or pins in response to user commands in each of the plurality of discrete area locations to facilitate at least one of assembly, test and diagnostic repair of the circuit board assembly.

### BRIEF DESCRIPTION OF THE DRAWINGS

FIG. 1 illustrates an example of a functional block diagram of a discrete area circuit board projection system.
FIG. 2 illustrates another example of a functional block diagram of a discrete area circuit board projection system.
FIGS. 3-6 illustrate a circuit card assembly during an example of an assembly procedure utilizing the system of FIG. 1 or FIG. 2.
FIGS. 7-8 illustrate the circuit board assembly undergoing a manual testing procedure.
FIGS. 9-10 illustrate the circuit board assembly undergoing a diagnostic repair procedure.
FIG. 11 illustrates an example of a user interface.
FIG. 12 is a schematic block diagram illustrating an example controller system.
FIG. 13 illustrates a method for controlling a drive signal to a resonator in accordance with an aspect of the present invention.

### DETAILED DESCRIPTION

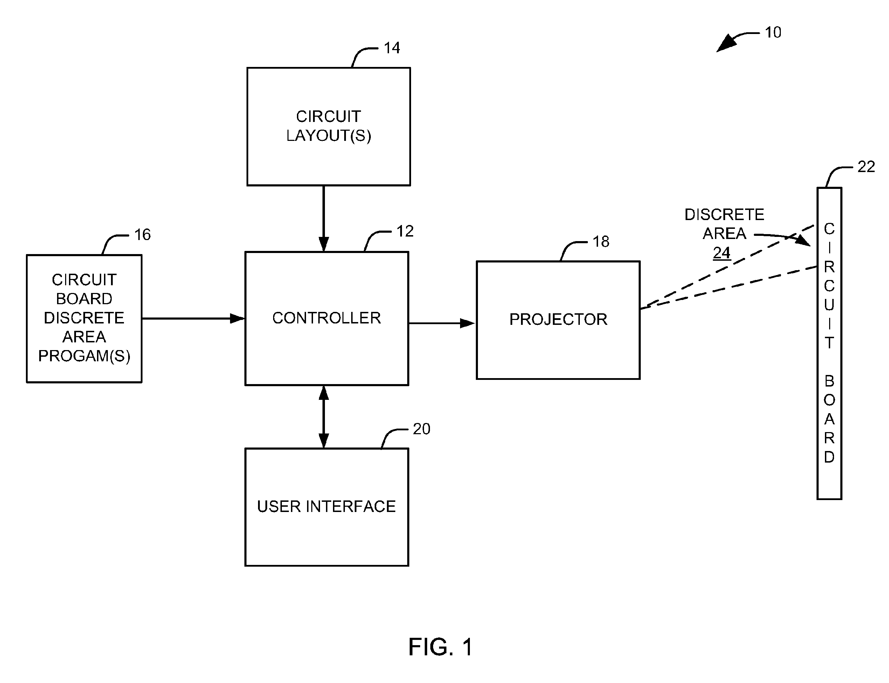

FIG. 1 illustrates an example of a functional block diagram of a discrete area circuit board projection system 10. The discrete area circuit board projection system 10 is configured to project images and orientations of components and pins at discrete area locations 24 on a circuit board assembly 22 to facilitate easy assembly, test and/or diagnostic repair. A plurality of images at different discrete area locations can be concurrently displayed, for example, when assembling similar parts, or sequentially displayed when assembling or testing components at different discrete area locations. The system 10 includes a controller 12 that receives one or more circuit layout(s) 14 and one or more circuit board discrete area program(s) 16. The one or more circuit layout(s) 14 can include pin and component layouts for one or more circuit boards that can be in a variety of different formats. For example, a circuit layout can be a cad file that is converted to a .pdf file for sequential display of different parts. Alternatively, the circuit layout can be in any file format or executable code (e.g., animation) that allows for display of images of circuit board pins (e.g., contact pins, test pins, probe pins, etc.) and/or circuit board components (e.g., integrated circuits, capacitors, resistors, inductors, dip switches, etc.).

An optional user interface 20 is provided that allows a user to select from a variety of circuit layouts 14 and/or circuit board discrete area programs 16. For example, a user can select an assembly program to facilitate circuit board assembly, a test program for testing the circuit board assembly for proper operation, a diagnostic program for facilitating repair of the circuit board assembly, or select a program that allows for a user to select one or more components and/or pins to be imaged onto the circuit board assembly at discrete area locations. The controller 12 generates video signals in response to execution of a circuit board discrete area program that is based on a circuit layout and generates video signals associated with images of components and/or pins to be displayed in a discrete area location or in a plurality of discrete area locations of a circuit board assembly. The video signals are provided to a display system in the form of a projector 18 for projection of the images of components and/or pins directly onto the circuit board assembly 22. The controller 12 can be a microcontroller, a microprocessor or a personal computer (PC). A user can sequentially step through images to be displayed at different discrete area locations on the circuit board assembly 22 via the user interface 20, or the controller 12 can automatically step through the images based on user input and/or timing set by the selected circuit board discrete area program.

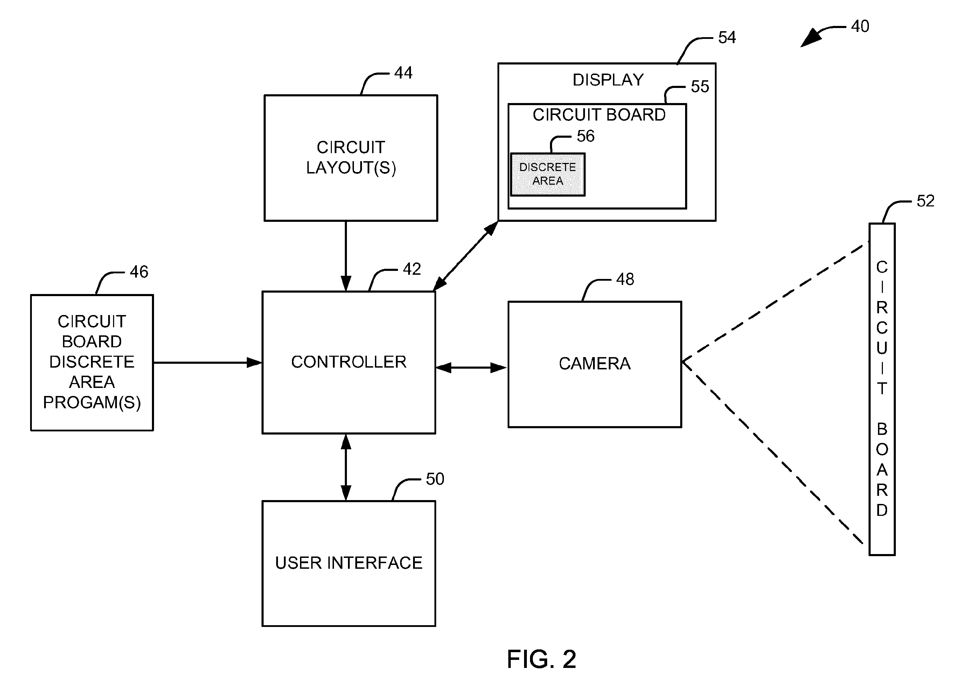

FIG. 2 illustrates another example of a functional block diagram of a discrete area circuit board projection system 40. The discrete area circuit board projection system 40 is configured to project images and orientations of components and pins at discrete area locations on the circuit board assembly to a discrete area location 56 on a display system 54 to facilitate easy assembly, test and/or diagnostic repair. The system 40 includes a controller 42 that receives one or more circuit layout(s) 44 and one or more circuit board discrete area program(s) 46. The one or more circuit layout(s) 44 can include pin and component layouts for one or more circuit boards that can be in a variety of different formats. An optional user interface 50 is provided that allows a user to select from a variety of circuit layouts 44 and/or circuit board discrete area programs 46.

The controller 42 is coupled to a camera 48 which captures an image of the circuit board, an assembler's fingers and any component that the assembly is holding over the circuit board assembly 52 in a view region of the camera 48. The controller 42 generates video signals in response to execution of a circuit board discrete area program that is based on a circuit layout and generates video signals associated with images of components and/or pins to be displayed in a discrete area location of a circuit board assembly. The controller 42 provides the captured images of the camera 48 and superimposes images of components and/or pins to be displayed overlying a captured image 55 of the circuit board assembly 52 at one or more discrete locations 56 to the display system 54. The display system 54 can be a computer display system, or a projector and a screen display that concurrently displays the projected images of components and/or pins with the captured images in the camera's view region. In this manner, the user can manual work on the circuit board assembly 52, while viewing the projected images and displayed captured images in the view of the circuit board assembly 52 from the display system 54. A user can sequentially step through images to be displayed at different discrete area locations on the circuit board assembly 55 via the user interface 50, or the controller 42 can automatically step through the images based on user input and/or timing set by the selected circuit board discrete area program.

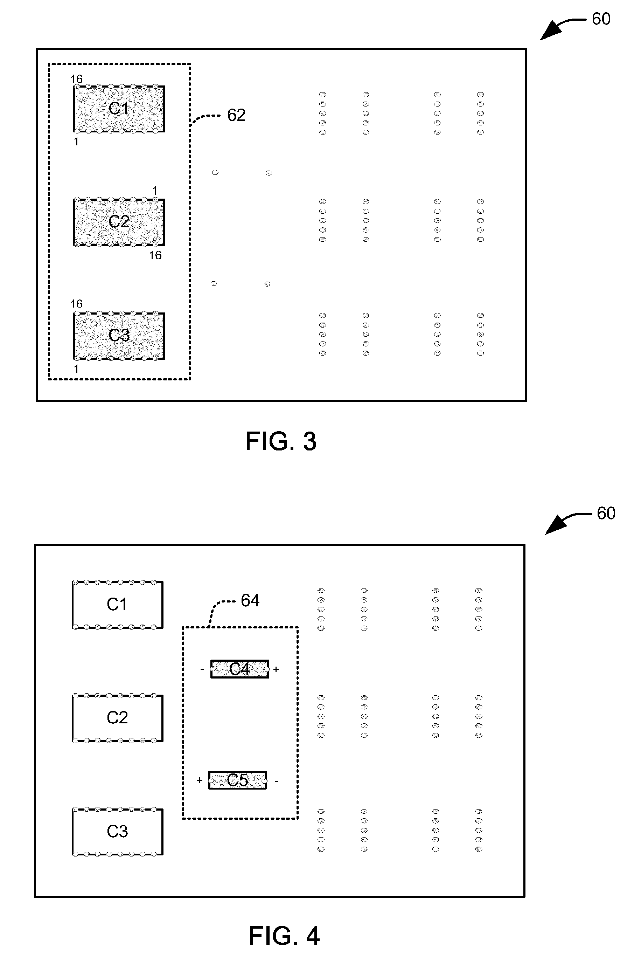

FIGS. 3-6 illustrate a circuit card assembly during an example of an assembly procedure utilizing the system of FIG. 1 or FIG. 2. FIG. 3 illustrates a top view of a circuit board assembly 60 in which an image is projected of a plurality of components labeled, C1-C3, in a first discrete area location 62 on the circuit board assembly 60. As shown the first pin reference and last pin reference of each component along with a reference number and an image of the component is displayed overlying the contact pins of the circuit board for each respective component. It is appreciated that the contact pins and reference pins can be displayed without displaying an image of the component. An assembler can then install the components C1-C3 onto the circuit board assembly 60 in the designated reference locations.

FIG. 4 illustrates a top view of the circuit board assembly 60 in which an image is projected of a plurality of components labeled, C4-C5, in a second discrete area location 64 on the circuit board assembly 60. As shown the first pin reference and last pin reference of each component along with a reference number and an image of the component is displayed overlying the contact pins of the circuit board assembly 60 for each respective component. A positive and negative polarity designator is shown for components C4-C5, such that an assembler is assured of installing components C4-C5 in their correct polarity position. Also, the components C1-C3 have been installed in the first discrete area location 62. An assembler can then install the components C4-C5 onto the circuit board assembly in the designated reference locations.

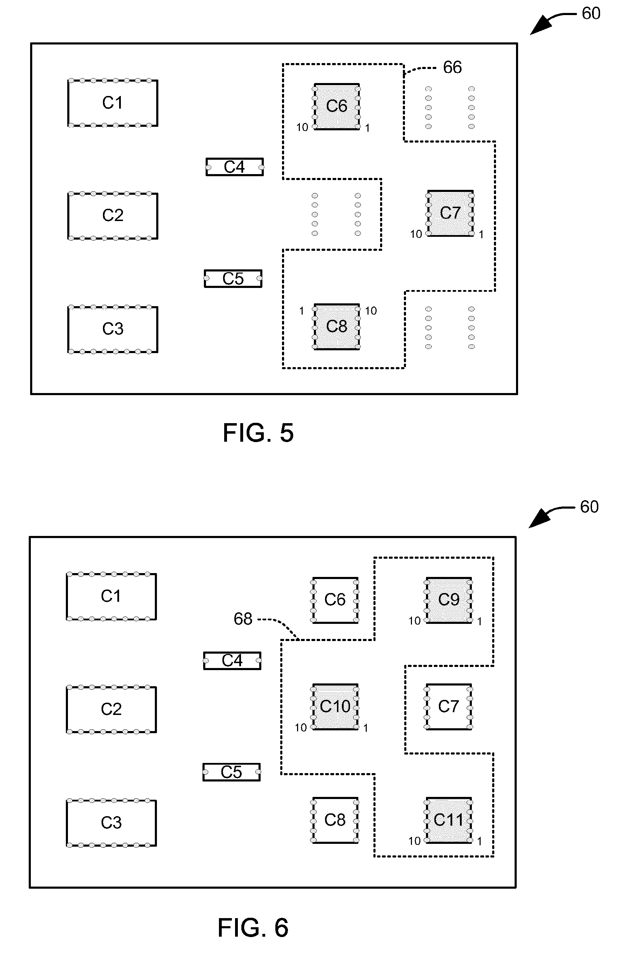

FIG. 5 illustrates a top view of the circuit board assembly 60 in which an image is projected of a plurality of components labeled, C6-C8, in a third discrete area location 66 on the circuit board assembly 60. As shown, the first pin reference and last pin reference of each component along with a reference number and an image of the component is displayed overlying the contact pins of the circuit board assembly 60 for each respective component. Also, the components C4-C5 have been installed in the second discrete area location 64. An assembler can then install the components C6-C8 onto the circuit board assembly 60 in the designated reference locations.

FIG. 6 illustrates a top view of the circuit board assembly 60 in which an image is projected of a plurality of components labeled, C9-C11, in a fourth discrete area location 68 on the circuit board assembly 60. In the example of FIG. 6, each of the plurality of components have the same number of pins and look substantially identical to the components in discrete area location 66, but are functionally different. As shown the first pin reference and last pin reference of each component along with a reference number and an image of the component is displayed overlying the contact pins of the circuit board assembly 60 for each respective component. Therefore, an assembler can then install the components C9-C11 onto the circuit board in the designated reference locations in the correct orientation to complete the circuit card assembly 60 for each respective component. Also, the components C6-C8 have been installed in the third discrete area location 66.

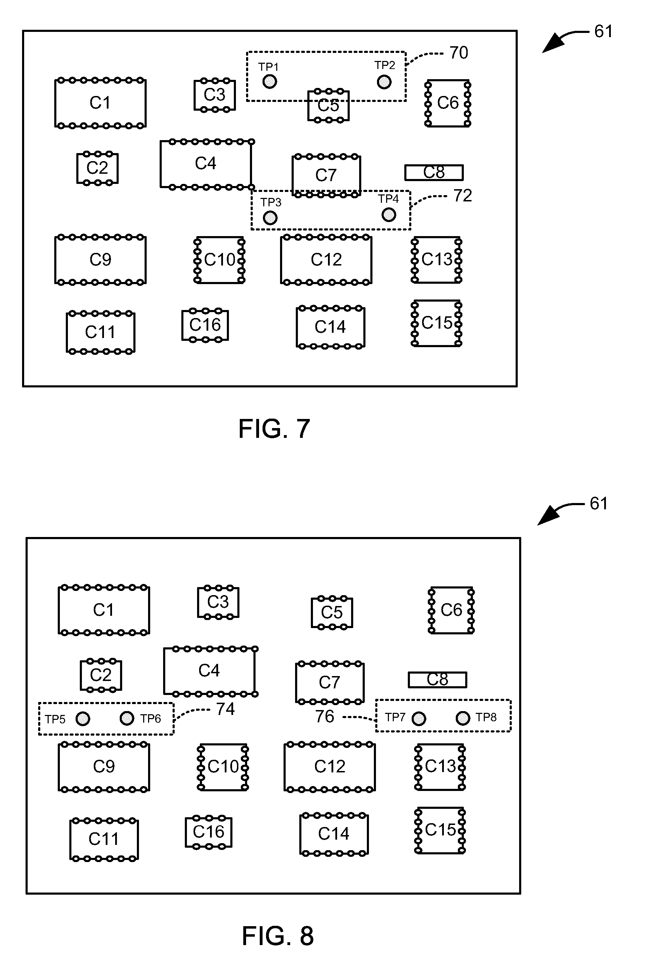

FIGS. 7-8 illustrate a circuit board assembly 61 undergoing a manual testing procedure. FIG. 7 illustrates a top view of the circuit board assembly in which an image is projected of a first pair of test points TP1 and TP2 in a fifth discrete area location 70 on the circuit board assembly 61 and an image is projected of a second pair of test points TP3 and TP4 on a sixth discrete area location 72. A user may be prompted on a user interface to place a voltage meter or oscilloscope between TP1 and TP2 and either confirm or enter a result from the reading. A user may then be prompted on a user interface to place a voltage meter or oscilloscope between TP3 and TP4 and either confirm or enter a result from the reading.

FIG. 8 illustrates a top view of the circuit board assembly 61 in which an image is projected of a third pair of test points TP5 and TP6 in a seventh discrete area location 74 on the circuit board assembly and an image is projected of a fourth pair of test points TP7 and TP8 on an eight discrete area location 76. A user may be prompted on a user interface to place a voltage meter or oscilloscope between TP5 and TP6 and either confirm or enter a result from the reading. A user may then be prompted on a user interface to place a voltage meter or oscilloscope between TP7 and TP8 and either confirm or enter a result from the reading. The user display may display results of the test for each measurement or a single "Pass" or "Fail" indication.

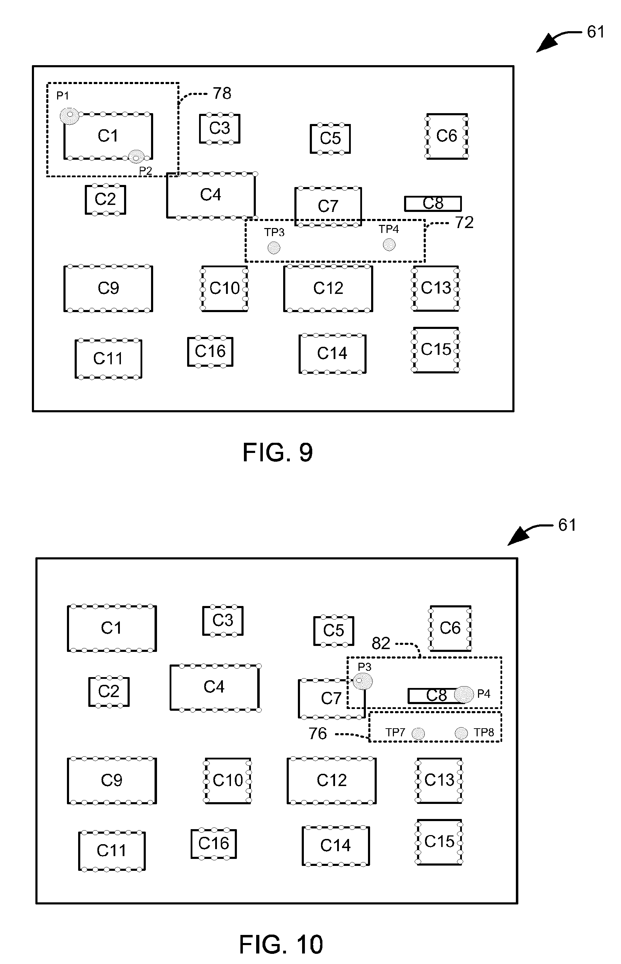

FIGS. 9-10 illustrate the circuit board assembly 60 undergoing a diagnostic repair procedure. FIG. 9 illustrates a top view of the circuit board assembly 60 in which an image is projected of a first pin P1 and a second pin P2 of the component C1 in a ninth discrete area location 78 and an image is projected of the second pair of test points TP3 and TP4 in the sixth discrete area location 72. A user may be prompted on a user interface to place a voltage meter or oscilloscope between the first pin P1 and the second pin P2 and either confirm or enter a result from the reading. A user may then be prompted on a user interface to place a voltage meter or oscilloscope between TP3 and TP4 and either confirm or enter a result from the reading.

FIG. 10 illustrates a top view of the circuit board assembly 60 in which an image is projected of a third pin P3 of the component C7 and a fourth pin P2 of the component C8 in a tenth discrete area location 80 on the circuit board assembly 60 and an image is projected of the fourth pair of test points TP7 and TP8 on the sixth discrete area location 76. A user may be prompted on a user interface to place a voltage meter or oscilloscope between pins P3 and P4 and either confirm or enter a result from the reading. A user may then be prompted on a user interface to place a voltage meter or oscilloscope between TP7 and TP8 and either confirm or enter a result from the reading. The user display may display results of the diagnostic repair and/or instructions for repairing the circuit board assembly 60, which may include further displaying of various components and pins in discrete area locations during the repair.

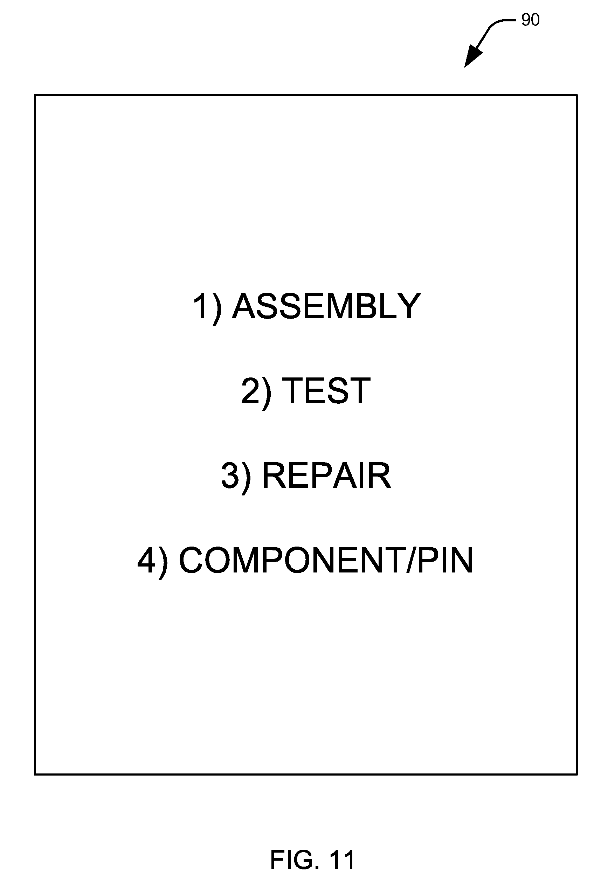

FIG. 11 illustrates an example of a user interface 90 in which a user can select between different procedures for operating the system of FIG. 1 or FIG. 2. The user interface allows a user to select between an assembly procedure, a test procedure, a repair procedure or a specific component/ pin. Selection of one of the procedure options will result in the specific display interfaces for that selected procedure invoking one or more circuit board discrete area programs and one or more circuit layouts as previously discussed, so that components and/or pins can be displayed at one or more discrete area locations of a circuit board during the selected procedure.

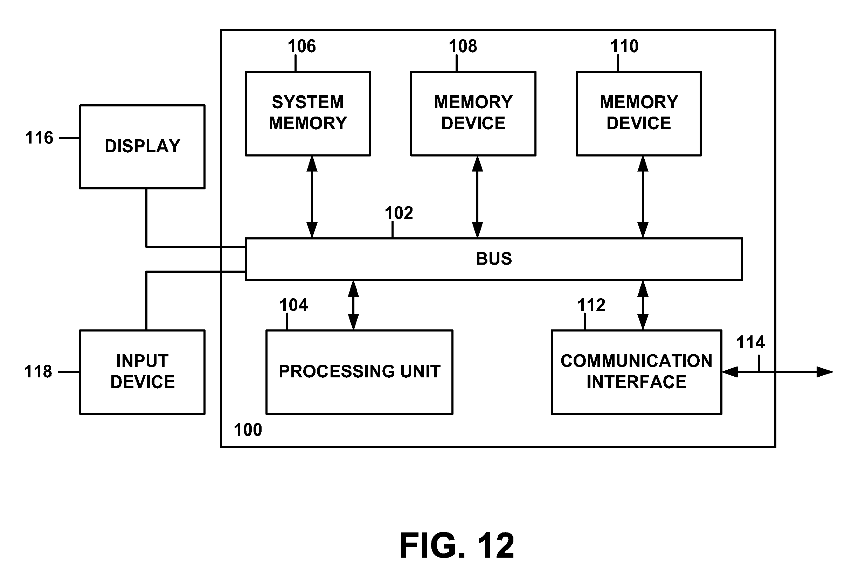

FIG. 12 is a schematic block diagram illustrating an example controller system 100 of hardware components capable of implementing examples disclosed in FIGS. 1-11, such as the controllers illustrated in FIGS. 1-2, the assembly procedure illustrated in FIGS. 3-6, the test procedure illustrated in FIGS. 7-8, the diagnostic repair procedure illustrated in FIGS. 9-10 and the GUI illustrated in FIG. 11. The system 100 can include various systems and subsystems. The system 100 can be a personal computer, a laptop computer, a workstation, a computer system, an appliance, an application-specific integrated circuit (ASIC), a server, a server blade center, a server farm, a mobile device, such as a smart phone, a personal digital assistant, an interactive television set, an Internet appliance, portions of a printer, etc.

The system 100 can include a system bus 102, a processing unit 104, a system memory 106, memory devices 108 and 110, a communication interface 112 (e.g., a network interface), a communication link 114, a display 116 (e.g., a video screen), and an input device 118 (e.g., a keyboard and/or a mouse). The system bus 102 can be in communication with the processing unit 104 and the system memory 106. The additional memory devices 108 and 110, such as a hard disk drive, server, stand alone database, or other non-volatile memory, can also be in communication with the system bus 102. The system bus 102 operably interconnects the processing unit 104, the memory devices 106-110, the communication interface 112, the display 116, and the input device 118. In some examples, the system bus 102 also operably interconnects an additional port (not shown), such as a universal serial bus (USB) port.

The processing unit 104 can be a computing device and can include an application-specific integrated circuit (ASIC). The processing unit 104 executes a set of instructions to implement the operations of examples disclosed herein. The processing unit can include a processor core. The additional memory devices 106, 108 and 110 can store data, programs, instructions, database queries in text or compiled form, and any other information that can be needed to operate a computer. The memories 106, 108 and 110 can be implemented as computer-readable media (integrated or removable) such as a memory card, disk drive, compact disk (CD), or server accessible over a network. In certain examples, the memories 106, 108 and 110 can comprise text, images, video, and/or audio.

In operation, the system 100 can be used to implement, for example, circuit board discrete area programs based on circuit layouts to display components and/or pins at discrete area locations. Machine (e.g., computer) executable logic for implementing the system can reside in the system memory 106, and/or in the memory devices 108 and/or 110 in accordance with certain examples. The processing unit 104 executes machine readable instructions originating from the system memory 106 and the memory devices 108 and 110.

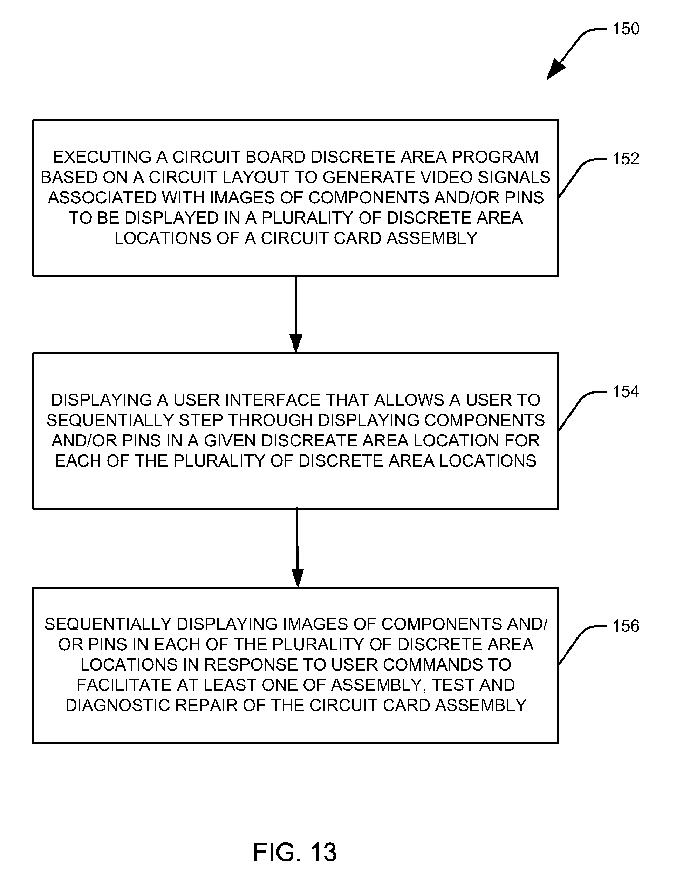

FIG. 13 illustrates a flow diagram of an example method for facilitating at least one of assembly, test and diagnostic repair of a circuit board assembly. The method begins at 152 where a circuit board discrete area program based on a circuit layout is executed to generate video signals associated with images of components and/or pins to be displayed in a plurality of discrete area locations of a circuit board assembly. At 154, a user interface is displayed that allows a user to sequentially step through displaying of the components and/or pins in a given discrete area location for each of the plurality of discrete area locations. At 156, the images of components and/or pins in response to user commands are sequentially displayed in in each of the plurality of discrete area locations to facilitate at least one of assembly, test and diagnostic repair of the circuit board assembly.

What have been described above are examples of the invention. It is, of course, not possible to describe every conceivable combination of components or methodologies for purposes of describing the invention, but one of ordinary skill in the art will recognize that many further combinations and permutations of the invention are possible. Accordingly, the invention is intended to embrace all such alterations, modifications, and variations that fall within the scope of this application, including the appended claims.

## Claims

1. A discrete area circuit board projection system comprising:
a controller that executes a circuit board discrete area program based on a circuit layout and generates video signals associated with images of components and/or pins to be displayed in a discrete area location of a circuit board assembly; and
a display system that receives the video signal and displays the images of components and/or pins in the discrete area location of the circuit board assembly to facilitate at least one of assembly, test and diagnostic repair of the circuit board assembly.

2. The system of claim 1, wherein the display system is a projector that projects the images of components and/or pins directly in the discrete area location of the circuit board assembly.

3. The system of claim 1, wherein the display system is one of a computer monitor or a projector and screen.

4. The system of claim 3, further comprising a camera that captures images of the circuit board assembly and any components and user's fingers in the view of the camera, which are provided to the display system for displaying along with the images of components and/or pins superimposed in the discrete area location of the captured image of the circuit board assembly.

5. The system of claim 1, wherein the video signals are associated with images of components and/or pins to be concurrently displayed in a plurality of discrete area locations of a circuit board assembly, and the display system receives the video signals and displays the images of components and/or pins concurrently in the plurality of discrete area locations of the circuit board assembly.

6. The system of claim 1, wherein the video signals are associated with images of components and/or pins to be sequentially displayed in a plurality of discrete area locations of a circuit board assembly, and the display system receives the video signals and displays the images of components and/or pins sequentially in the plurality of discrete area locations of the circuit board assembly.

7. The system of claim 6, further comprising a user interface that allows a user to sequentially step through displaying of the components and/or pins in a given discrete area location for each of the plurality of discrete area locations.

8. The system of any preceding claim, further comprising a user interface that prompts the user to measure pins of components and/or other pins with a meter or oscilloscope that are displayed in one or more discrete area locations during one of a test and/or diagnostic repair procedure.

9. The system of any preceding claim, further comprising a user interface that allows a user to select at least one of an assembly procedure, a test procedure, a diagnostic test procedure and a discrete component and/or pin to be displayed on a circuit board assembly.

10. A method for facilitating at least one of assembly, test and diagnostic repair of a circuit board assembly, the method comprising:
executing a circuit board discrete area program based on a circuit layout to generate video signals associated with images of components and/or pins to be displayed in a plurality of discrete area locations of a circuit board assembly; and
displaying a user interface that allows a user to sequentially step through displaying of the components and/or pins in a given discrete area location for each of the plurality of discrete area locations; and
sequentially displaying the images of components and/or pins in each of the plurality of discrete area locations in response to user commands to facilitate at least one of assembly, test and diagnostic repair of the circuit board assembly.

11. The method of claim 10, wherein the images are displayed directly on the circuit board assembly.

12. The method of claim 10, wherein the images are superimposed over images of the circuit board assembly and any components and user's fingers overlying the actual circuit board assembly in a display.

13. The method of any one of claims 10 to 12, further comprising displaying a user interface that prompts the user to measure pins of components and/or other pins with a meter or oscilloscope that are displayed in given discrete area locations during one of a test and/or diagnostic repair procedure.

14. The method of any one of claims 10 to 12, further comprising displaying a user interface that allows a user to select at least one of an assembly procedure, a test procedure, a diagnostic test procedure and a discrete component and/or pin to be displayed on a circuit board assembly.
